# EUROPEAN PATENT APPLICATION

(11) **EP 0 686 707 A1**
(43) Date of publication of application: **13.12.1995**
(21) Application number: 94108885.8
(22) Date of filing: 09.06.1994
(51) Int. Cl.: C23C 16/02, C23C 30/00

(54) **Surface coated cutting tool**

(71) Applicant: MITSUBISHI MATERIALS CORPORATION, Chiyoda-ku, Tokyo (JP)
(72) Inventor: Ooshika, Takatoshi, c/o Tukuba Plant, Ishige-cho, Yuuki-gun, Ibaragi-ken (JP)
(74) Representative: Müller-Boré & Partner Patentanwälte

(57) **Abstract**

(Object)

The invention relates to a cutting tool whose surface is coated with a composite hard layer formed by means of chemical vapor deposition and having excellent wear resistance and chipping resistance.

(Construction)

A cutting tool consists substantially of a substrate whose surface is coated with a composite hard layer consisting substantially of an inner layer including one or more layers of titanium carbide, titanium nitride, titanium carbonitride, titanium carboxide, and titanium oxicarbonitride, and an outer layer including at least one alumina layer. The alumina layer contains so much κ-type alumina that an X-ray intensity ratio I_{A}/I_{B} of two specific crystal faces A and B in X-ray diffraction is not smaller than 2, where the A-face and B-face denote faces of κ-type alumina defined as those whose interfacial distances are 2.79Å and 2.57Å in ASTM4-0878, and I_{A} and I_{B} denote X-ray intensity of the faces A and B in X-ray diffraction.

## Description

### DETAILED DESCRIPTION OF THE INVENTION

### [Field of industrial application]

The present invention relates to a surface coated cutting tool having excellent wear resistance and chipping resistance, the cutting tool including a cemented carbide substrate whose surface is coated with a composite hard layer formed by means of chemical vapor deposition, the composite hard layer consisting substantially of an inner layer including one or more layers of titanium carbide, titanium nitride, titanium carbonitride, titanium carboxide, and titanium oxicarbonitride (hereinafter referred to generally as titanium compound layers), and an outer layer including at least one alumina layer.

### [Prior art]

For the purpose of continuous and interrupted cutting of steel, it has been well known practice to use a surface coated cutting tool including a cemented carbide substrate whose surface is coated with a composite hard layer formed by means of chemical vapor deposition, the composite hard layer consisting substantially of an inner layer including a titanium compound layer and an outer layer including at least one alumina layer.

The alumina layer is chemically stable and displays excellent face wear resistance, but it adheres poorly to the substrate and lacks toughness. Thus, the surface of the cemented carbide substrate is coated first with a titanium compound layer formed by means of chemical vapor deposition, then an alumina layer is formed on the titanium compound layer by means of chemical vapor deposition, thereby giving wear resistance and toughness to the formed composite hard layer to improve chipping resistance.

For the purpose of forming the alumina layer of the composite hard layer by means of chemical vapor deposition, a method is known for speeding up the growth rate of the alumina layer by using a reaction gas obtained by adding 0.01 to 1.0 vol % of hydrogen sulfide gas to the normal reaction gas.

The use of this method shortens the time during which the inner layer made of titanium compound and the cemented carbide substrate are held at high temperature, with the result that the structure of the inner layer and the substrate is unlikely to change. Thus, it is said that a surface coated cutting tool having a better performance than the conventional tools can be obtained according to this method (refer to, for example, Japanese Examined Patent Publication 62-3234).

The alumina layer obtained by using a reaction gas containing 0.01 to 1.0 vol % of hydrogen sulfide gas is mainly an α-type alumina layer. It is also known that a κ-type alumina layer is obtainable by changing the volume of carbon dioxide gas in the reaction gas.

### [Problems to be solved by the invention]

In recent years, there has been an increasing demand for a labor-saving and more rapid cutting operation. This demand strongly requires a high speed in continuous and interrupted cutting operation, that is both high speed feeding and high speed cutting under more severe conditions. During the high speed cutting operation, the temperature of the cutting edge rises above 1000°C and steel chips of exceedingly high temperature pass along the face of the cutting tool, which accelerates wear of the face. Thus, the cutting tool is chipped or damaged at a relatively early stage. Under these severe conditions, the cutting tools coated with the composite hard layer including the conventional alumina layer have a relatively short lifetime because the coated layer has insufficient wear resistance and chipping resistance.

### [Means for solving the problem]

In view of the above, the inventors of the present invention carried out a research to develop a cutting tool whose surface is coated with a composite hard layer including an alumina layer having better wear resistance and chipping resistance than the prior art and obtained the following results.

A cutting tool comprising a substrate whose surface is coated with a composite hard layer consisting substantially of an inner layer including one or more layers of titanium compounds, and an outer layer including at least one alumina layer containing so much κ-type alumina that an X-ray intensity ratio of two specific crystal faces in X-ray diffraction is not smaller than 2, has better wear resistance and chipping resistance than the conventional cutting tools coated with a composite hard layer including the conventional alumina layer.

The invention was developed on the basis of these research results and is directed to:
a cutting tool comprising a substrate whose surface is coated with a composite hard layer including an inner layer having one or more layers of titanium carbide, titanium nitride, titanium carbonitride, titanium carboxide, and titanium oxicarbonitride, and an outer layer having at least one alumina layer, wherein the alumina layer contains so much κ-type alumina that an X-ray intensity ratio I_{A}/I_{B} of two specific crystal faces A and B in X-ray diffraction is not smaller than 2, where the A-face and B-face denote faces of κ-type alumina defined as those whose interfacial distances are 2.79Å and 2.57Å in ASTM4-0878, and I_{A} and I_{B} denote X-ray intensities of the faces A and B in X-ray diffraction.

The reason why the cutting tool according to the invention has better wear resistance and better chipping resistance compared with the conventional tools is thought to be that abnormal damage caused by friction between steel chips and the tool is unlikely to occur because κ-type alumina, demonstrating orientation to the face A, makes the surface of the coated layer smooth.

Thus, when the alumina layer contains so much special κ-type alumina that the ratio of X-ray intensity I_{A} of the face A to that I_{B} of the face B in X-ray diffraction is not smaller than 2, i.e., I_{A}/I_{B} ≧ 2, wear resistance and chipping resistance are further improved. Thus, the cutting tool whose surface is coated with the composite hard layer including this alumina layer has a longer lifetime even under severe working conditions such as high speed cutting.

Besides special κ-type crystals whose X-ray intensity ratio (I_{A}/I_{B}) is not smaller than 2, the alumina layer according to the invention may contain alumina having a different crystallo-graphic structure. However, it is desirable that the amount of special κ-type crystals in the alumina layer be at least not less than 30 %, preferably not less than 50 %, and most preferably not less than 70 %. The percentage of special κ-type crystals is obtained from the following equation: 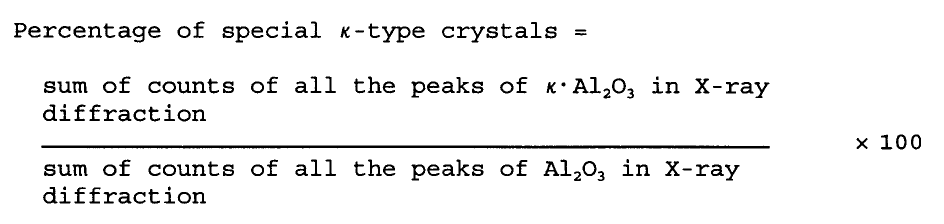
It is not necessary for the alumina layer to be an outer-most layer. At least one layer of titanium compound may be formed on the alumina layer.

A method for forming the inventive alumina layer containing special κ-type crystals whose peak intensity ratio (I_{A}/I_{B}) is not smaller than 2 is as follows.

During an alumina coating reaction, a substrate coated with titanium compounds is held in a mixed gas containing no CO₂ gas, but AlCl₃, H₂ and, if necessary, HCl for a predetermined time in the first step, and is subsequently caused to react in a mixed gas containing CO₂, AlCl₃, H₂ and, if necessary, HCl in the second step.

It will be appreciated that the mixed gas used for the coating reaction may further contain H₂S if necessary.

The conditions for the alumina coating reaction are described in detail below:

### First Step -

Temp. : 800 to 1050°C , Time : 1 to 120 min.
Gas Composition : 0.5 to 20 vol % of AlCl₃, 0 to 20 vol % of HCl, remainder H₂

### Second Step -

Temp. : 800 to 1050°C
Gas Composition : 0.5 to 30 vol % of CO₂, 0.5 to 20 vol % of AlCl₃, 0 to 20 vol % of HCl, remainder H₂
If necessary, 0.01 to 5 vol % of H₂S may be added at the beginning or in the middle of the second step. The composition of the mixed gas may be changed continuously during the transition from the first step to the second step.

### [Example]

The surface coated cutting tool according to the invention will be described in more detail by way of an example.

A mixed powder having the composition: 87%WC-2%TiC-1%TiN-4%TaC-6%Co was prepared according to a normal method. The mixed powder prepared in this way was compressed into a green compact, which was then sintered at a temperature of 1410° in vacuum for 1 hour. In this way, a cemented carbide substrate A of the form of ISO SNMG120408 was prepared.

Similarly, a mixed powder having the composition: 82%WC-5%TiC-5%TaC-8%Co was prepared according to a normal method. The mixed powder prepared in this way was compressed into a green compact, which was then sintered at a temperature of 1380° in vacuum for 1 hour. In this way, a cemented carbide substrate B of the form of ISO SNMG120408 was prepared.

On the surface of the cemented carbide substrate A, there was a tough surface layer of a thickness of 20 µm including substantially no hard disperse phase (Ti, Ta, W) (C, N) and having a Co-amount increased to a maximum of 1.8 times greater than the internal Co-amount. On the other hand, there was almost no difference in structure between the surface and internal portions of the cemented carbide substrate B.

Honing of as large as 0.05R (R is the radius of the edge of the cutting tool in mm) was applied to the cutting edges of the thus obtained cemented carbide substrates A and B, and the surfaces of the substrates were washed. The inventive surface coated cutting tools 1 to 8 were manufactured by coating the surface of the substrate A under the conditions specified in TABLE-1 to TABLE-7 and by coating the surface of the substrate B under the conditions specified in TABLE-8. For the purpose of comparison, the conventional surface coated cutting tools 1 to 8 were manufactured by coating the surface of the substrate A under the conditions specified in TABLE-9 to TABLE-15 and by coating the surface of the substrate B under the conditions specified in TABLE-16.

X-ray diffraction was conducted for the inventive cutting tools 1 to 8 and the conventional cutting tools 1 to 8 to measure the X-ray intensity ratio I_{A}/I_{B}. The measurement results are shown in TABLE-17.

Further, a continuous cutting test and an interrupted cutting test were conducted for the above cutting tools under the following conditions. A wear width on the flank face was measured in the former test, whereas the lapse of time until chipping was measured in the latter test. The measurement results in the respective tests are again shown in TABLE-17.

### [Cutting Test Conditions]

| - Continuous Cutting - | |
|---|---|
| Work piece | JIS SCM440 (hardness : H_{B} 220) round bar |
| Cutting speed | 250 m/min. |
| Feed rate | 0.3 mm/rev. |
| Cutting depth | 1.5 mm |
| Cutting time | 20 min. |
| Coolant | none |

| - Interrupted Cutting - | |
|---|---|
| Work piece JIS | SNCM439 (hardness : H_{B} 280) rectangular bar |
| Cutting speed | 100 m/min. |
| Feed rate | 0.236 mm/rev. |
| Cutting depth | 3.0 mm |
| Cutting time | 30 min. |
| Coolant | none |

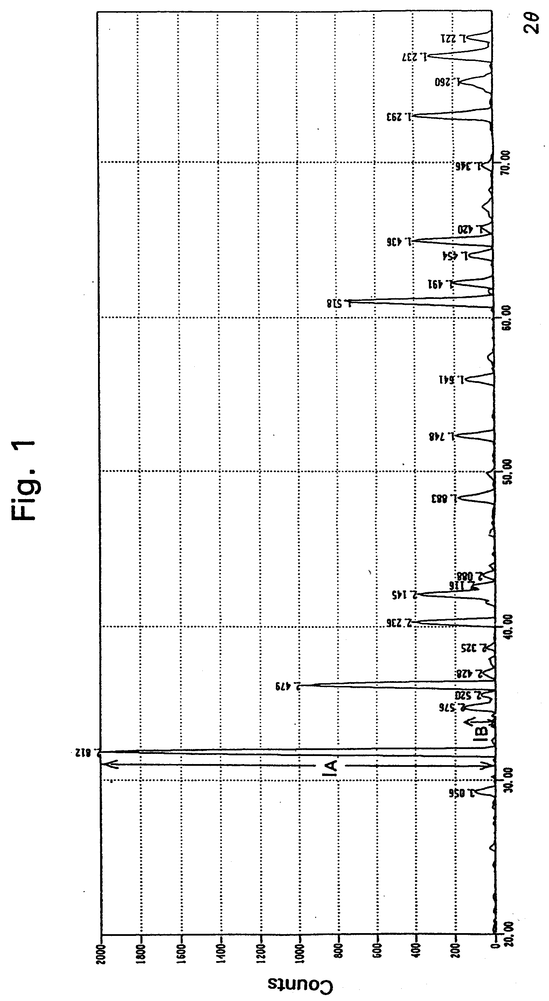

TABLE-18, the ASTM table, defines faces by means of face index [indicated in (h, k, l)], but the specific faces of this κ-Al₂O₃ are not yet identified. "Face A" and "face B" have been written in a blank column of this table in order to identify the faces. Fig. 1 is a graph showing X-ray diffraction data of the coating layer of the inventive cutting tool 5 in the example. I_{A} and I_{B} represent x-ray intensities of the faces A and B. A theoretical d-value of the face A is 2.79 according to TABLE-18, but a measured d-value thereof is 2.812 which varies slightly from the theoretical d-value. The theoretical and measured d-values of the face B are 2.57 and 2.576, respectively. The horizontal axis of Fig. 1 represents 2ϑ which is an angle (in degree) an X-ray makes in the X-ray diffraction. Numerical values (2.812, 2.576, etc.) written on the respective peaks in this graph denote an interfacial distance d (in Å).

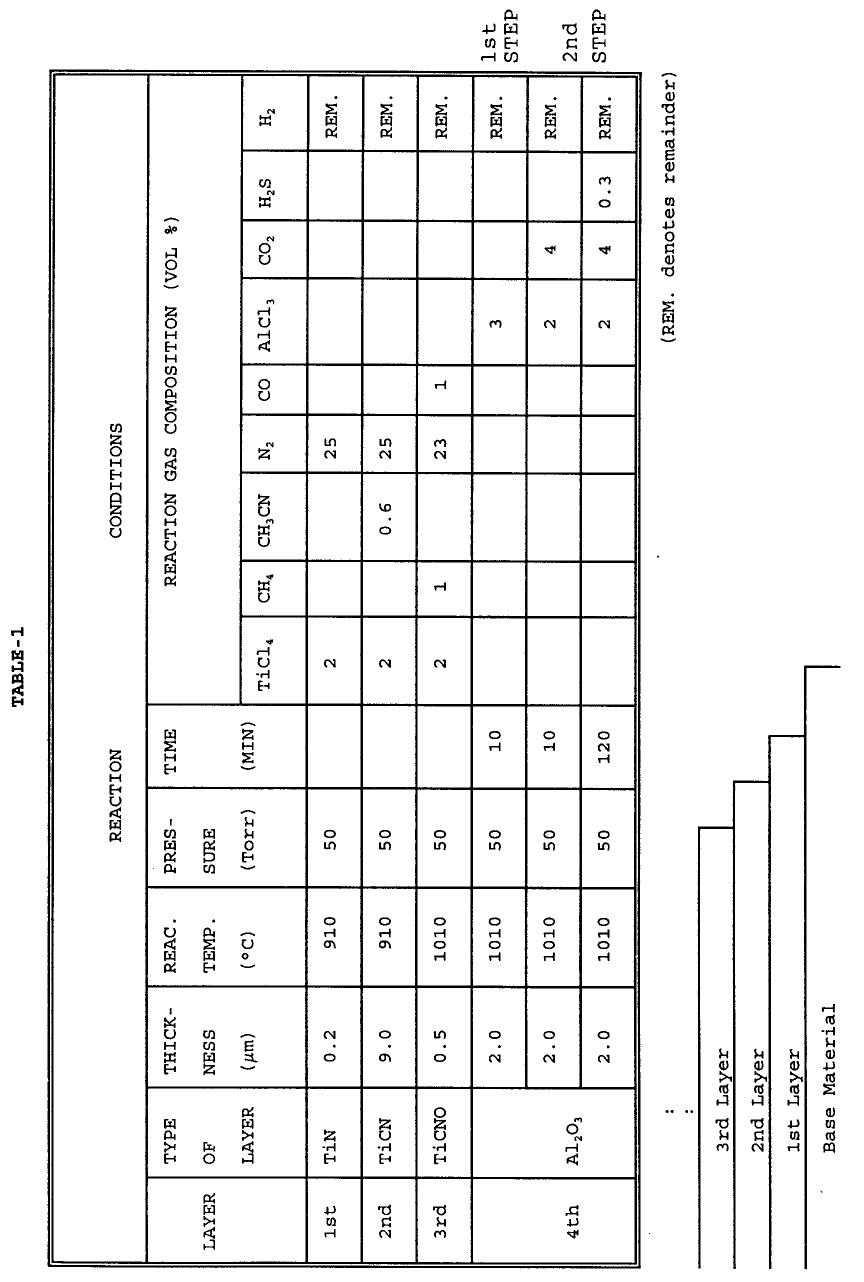

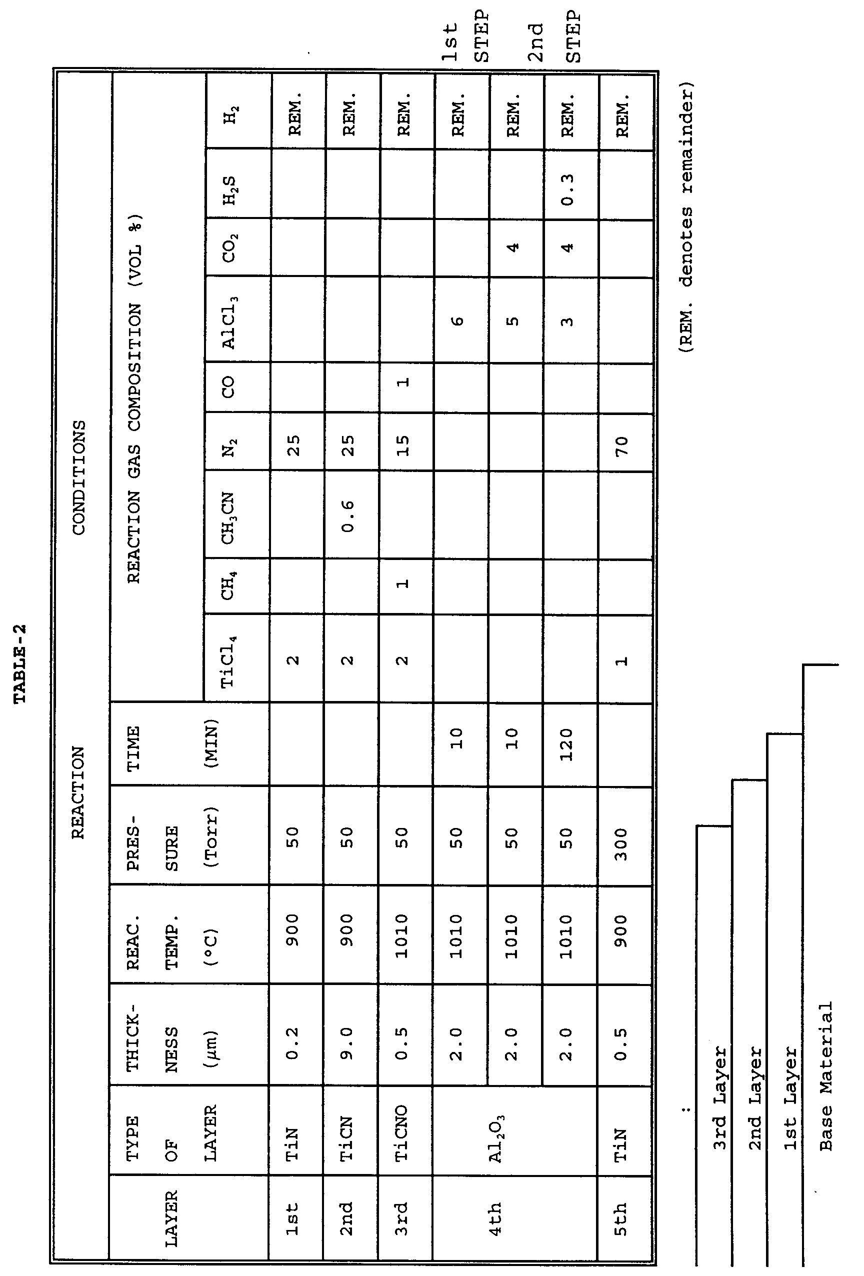

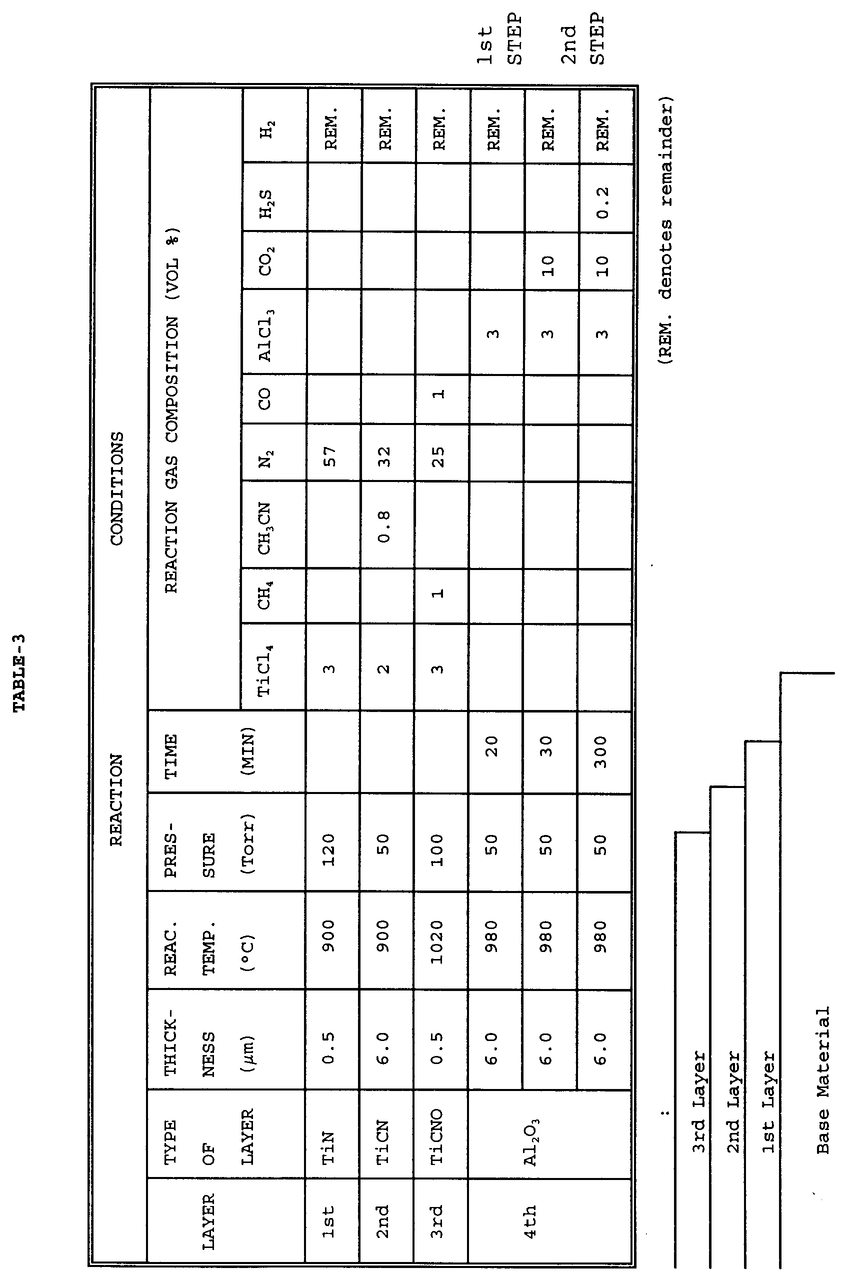

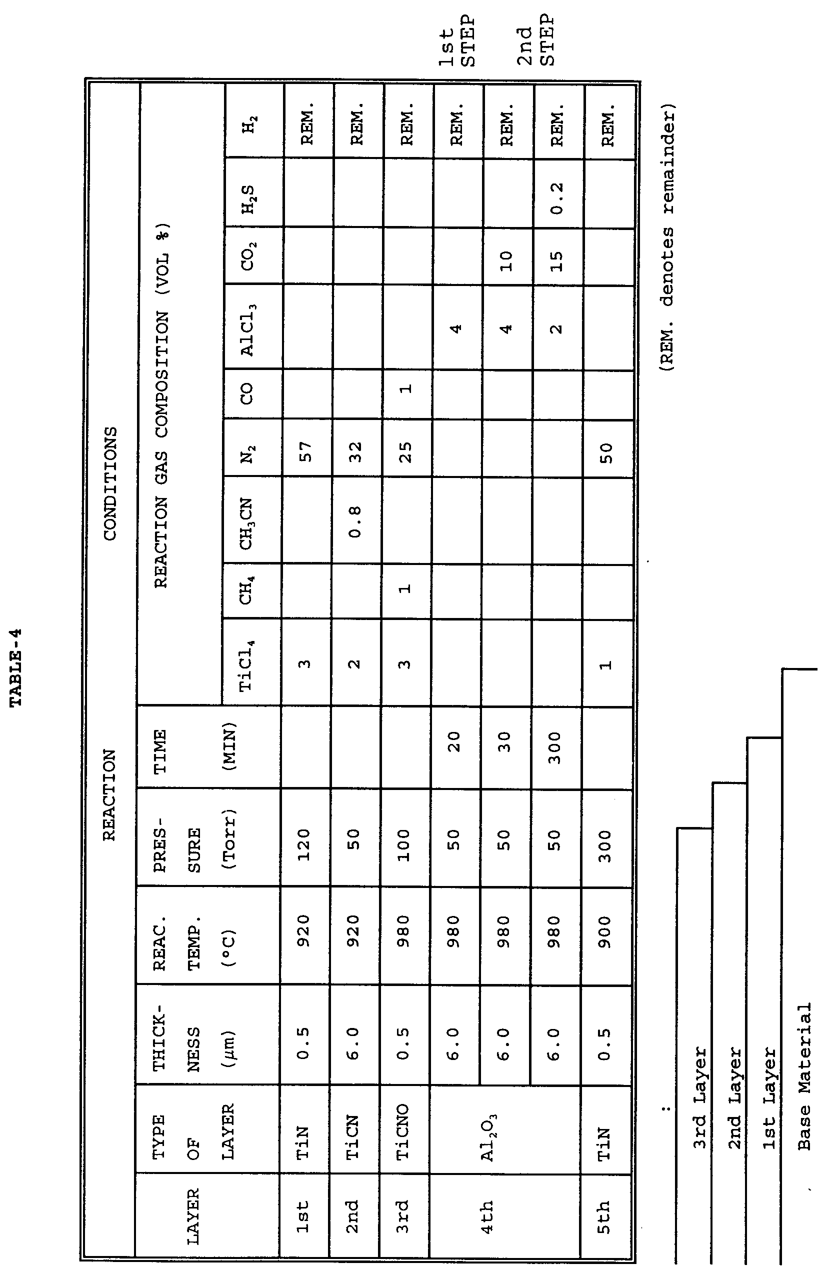

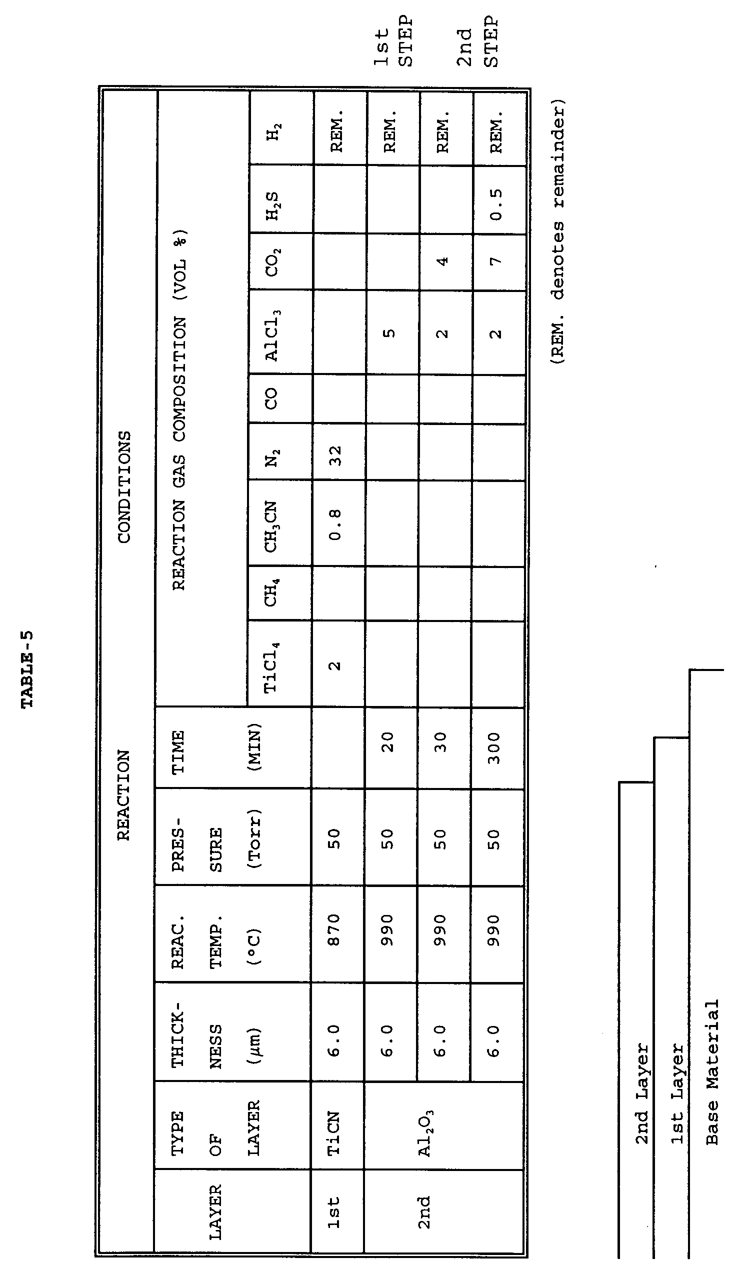

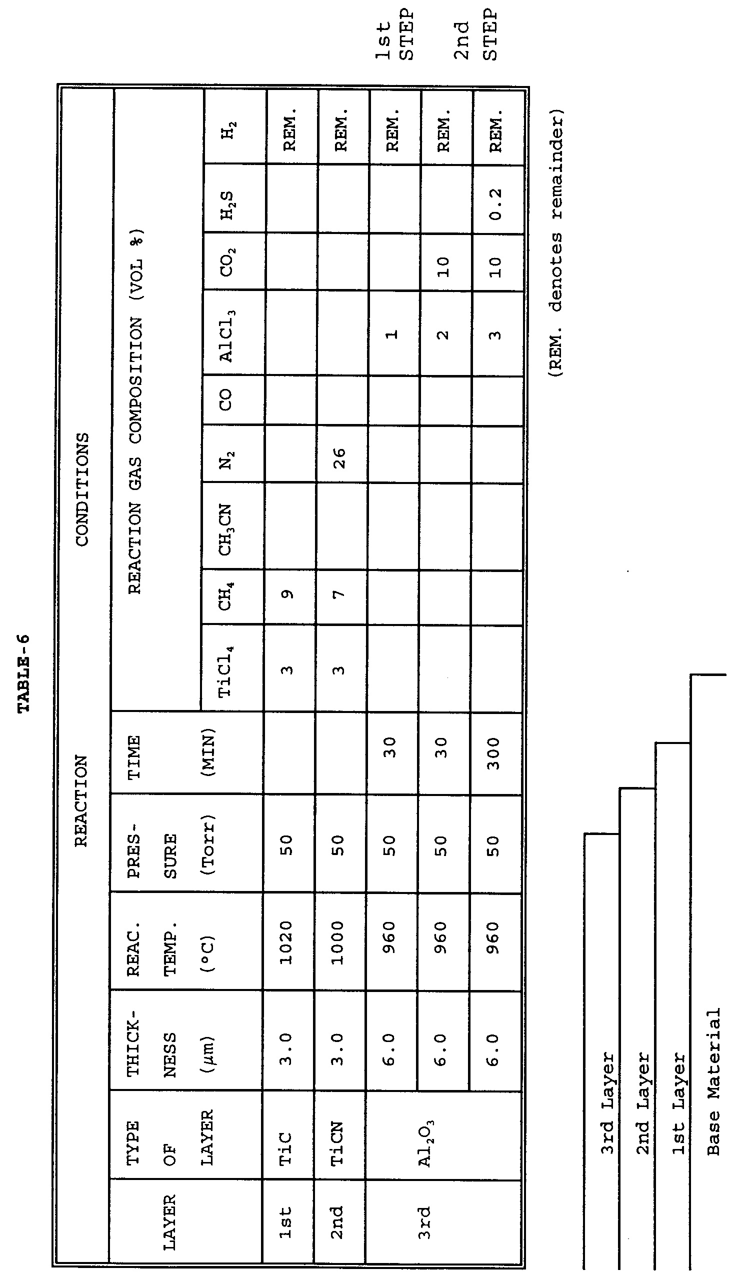

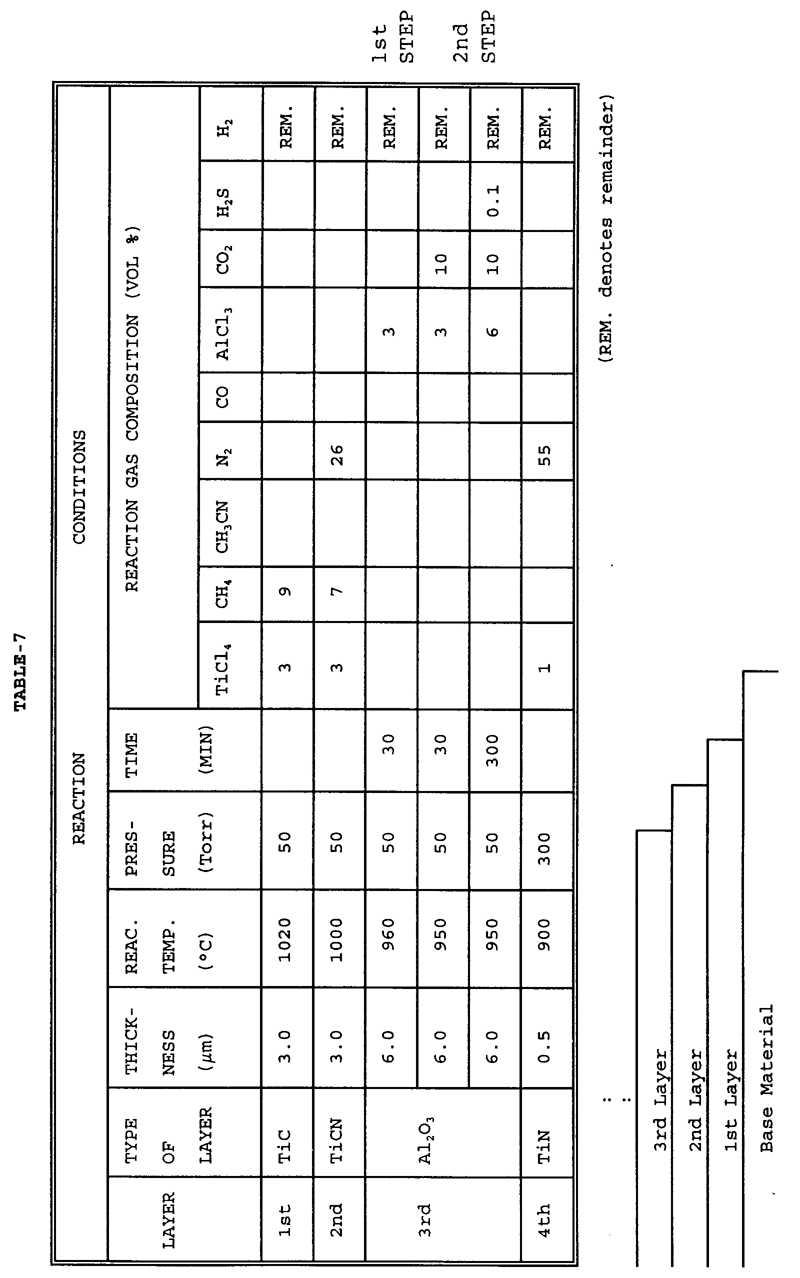

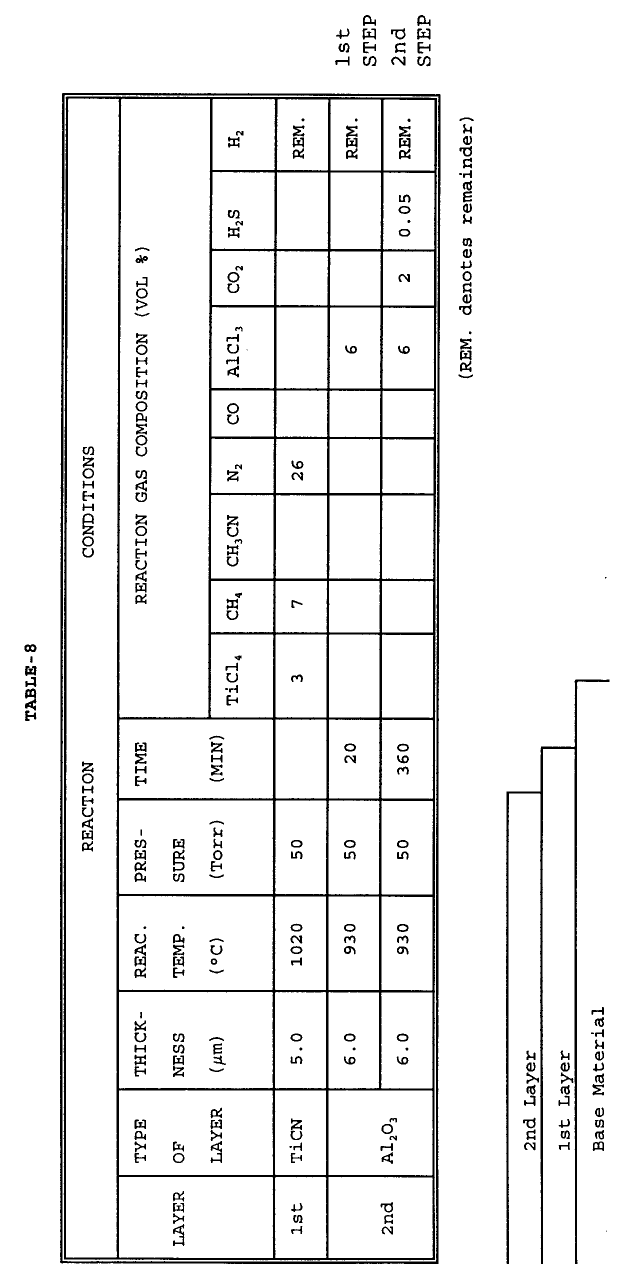

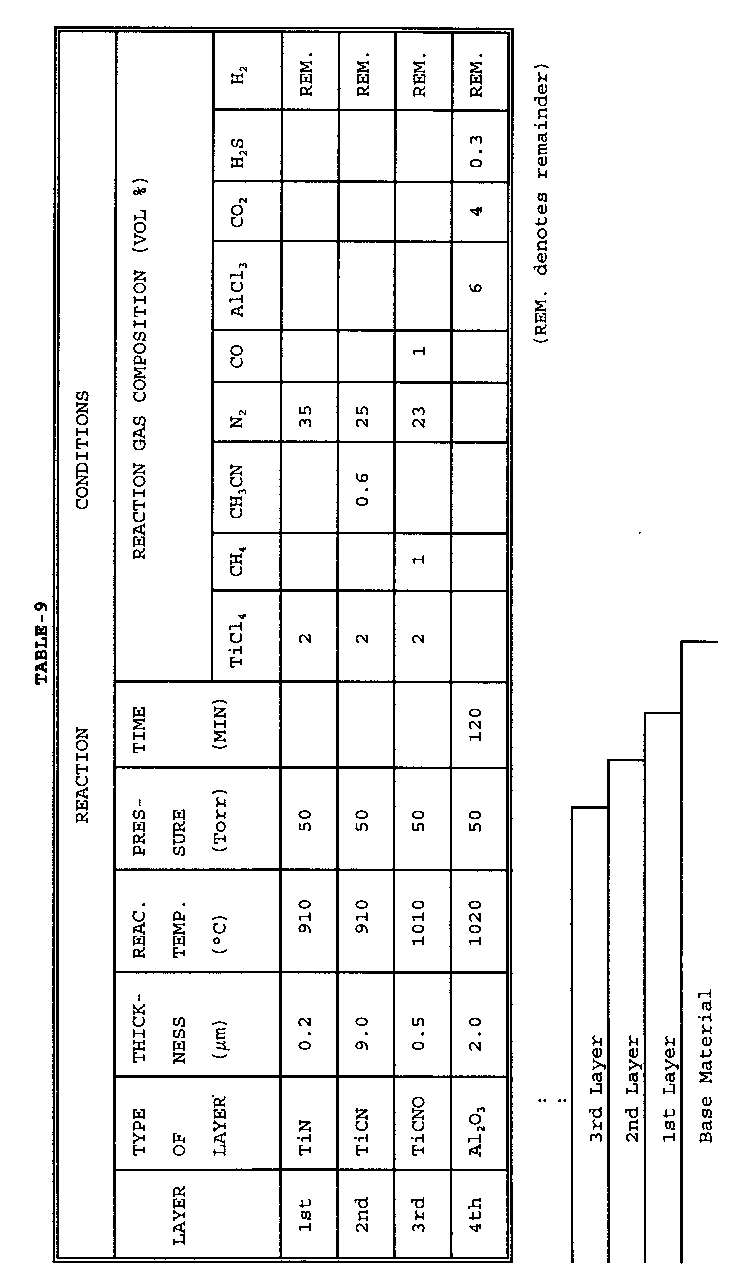

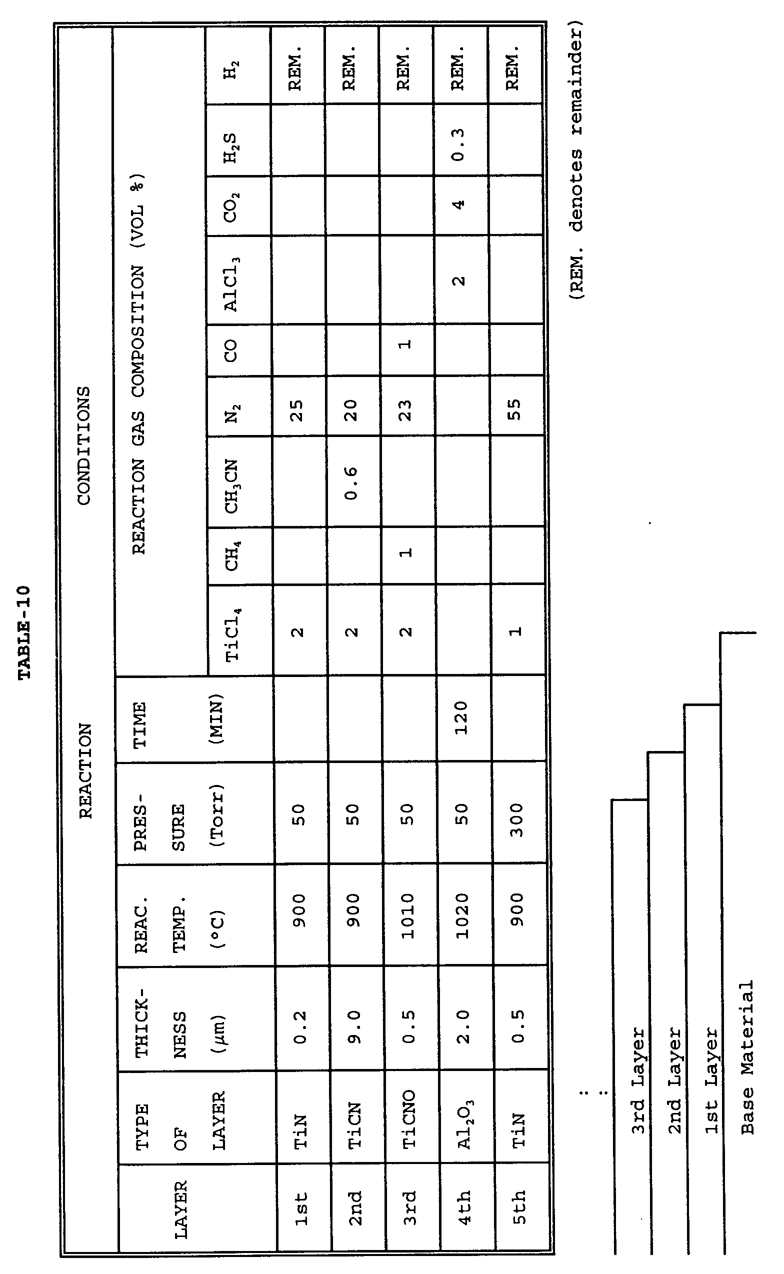

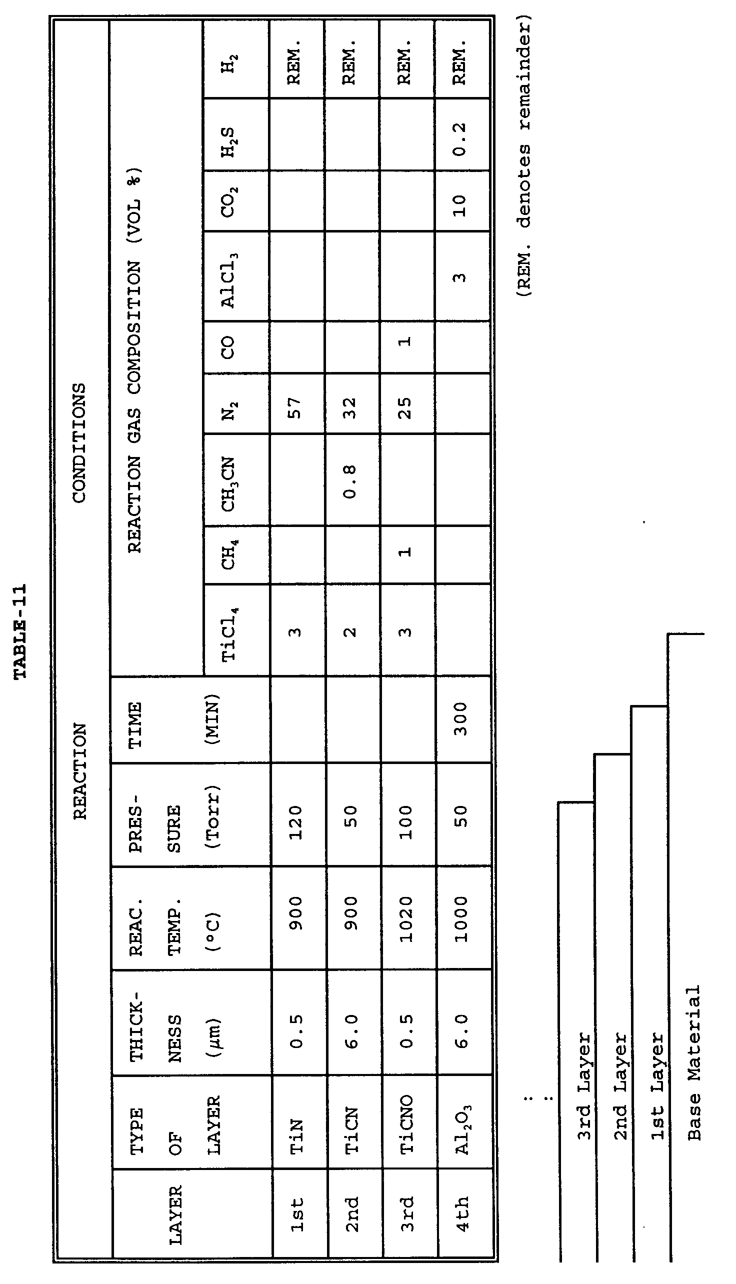

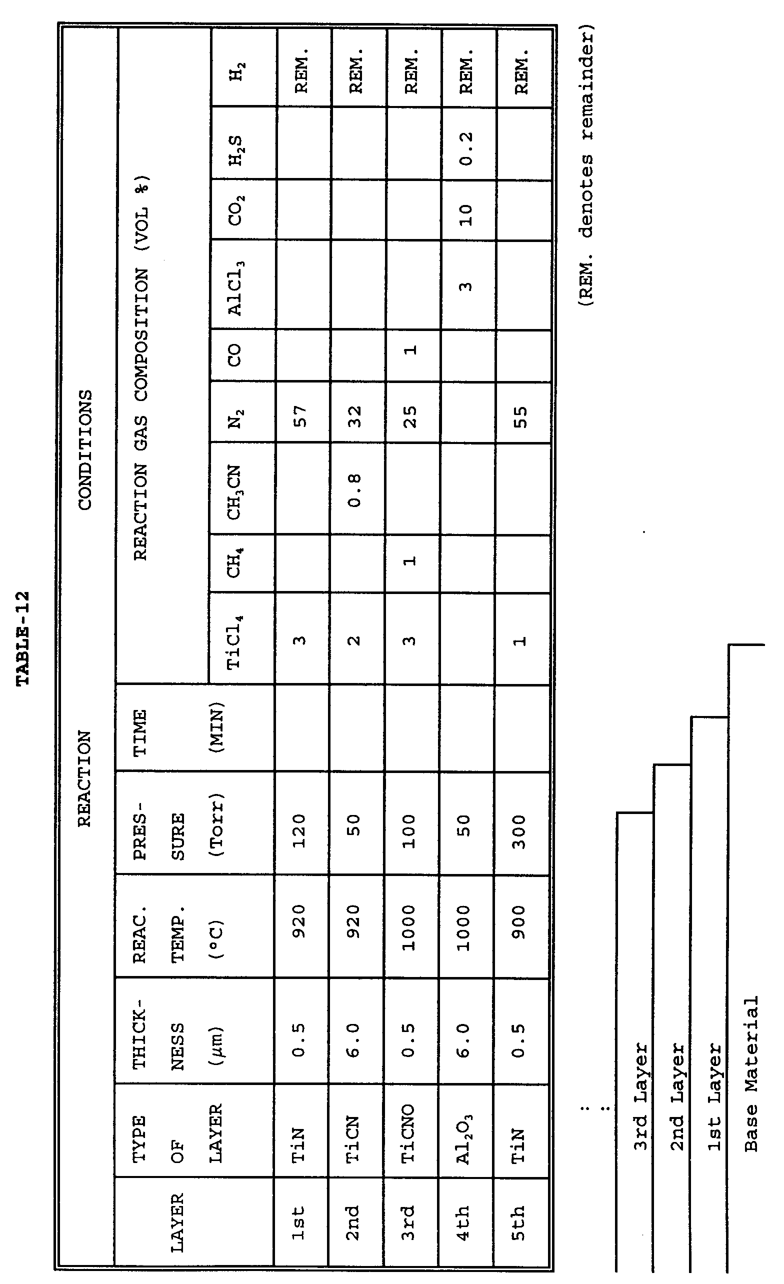

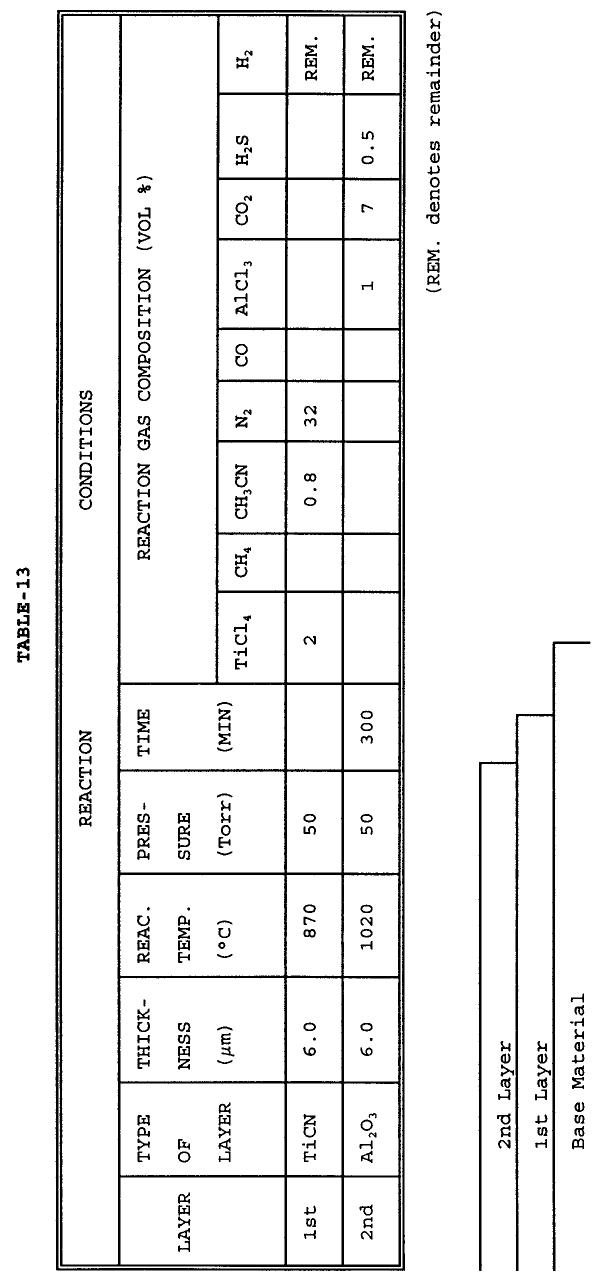

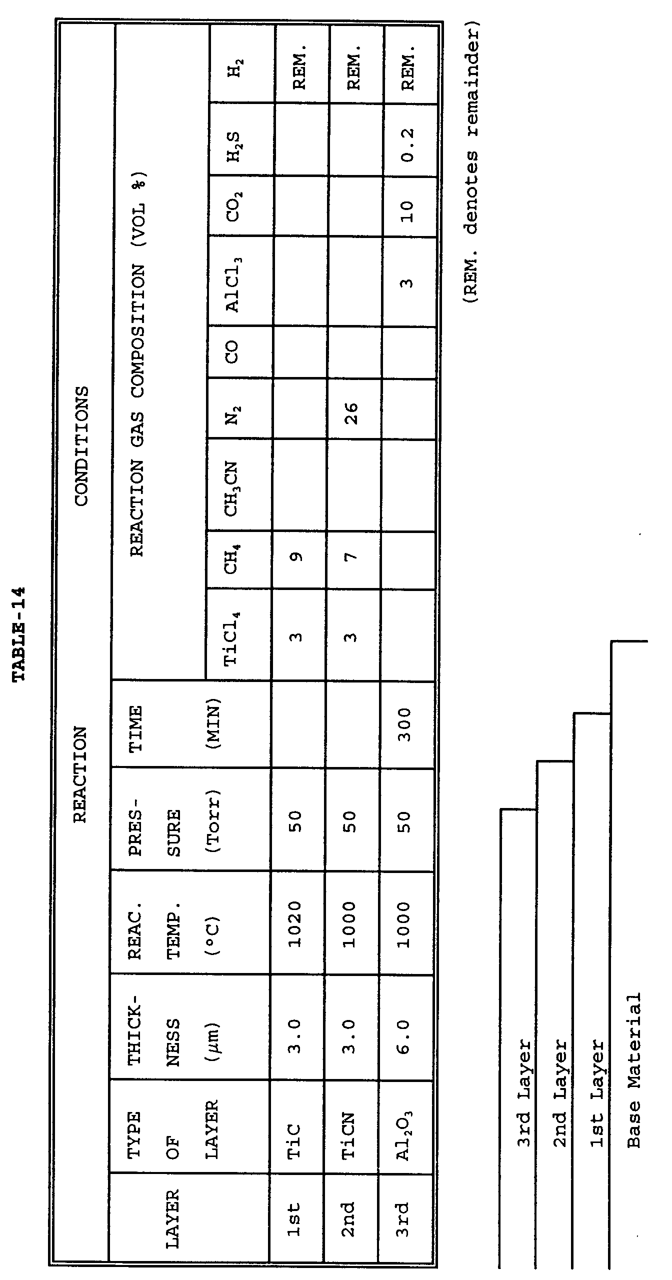

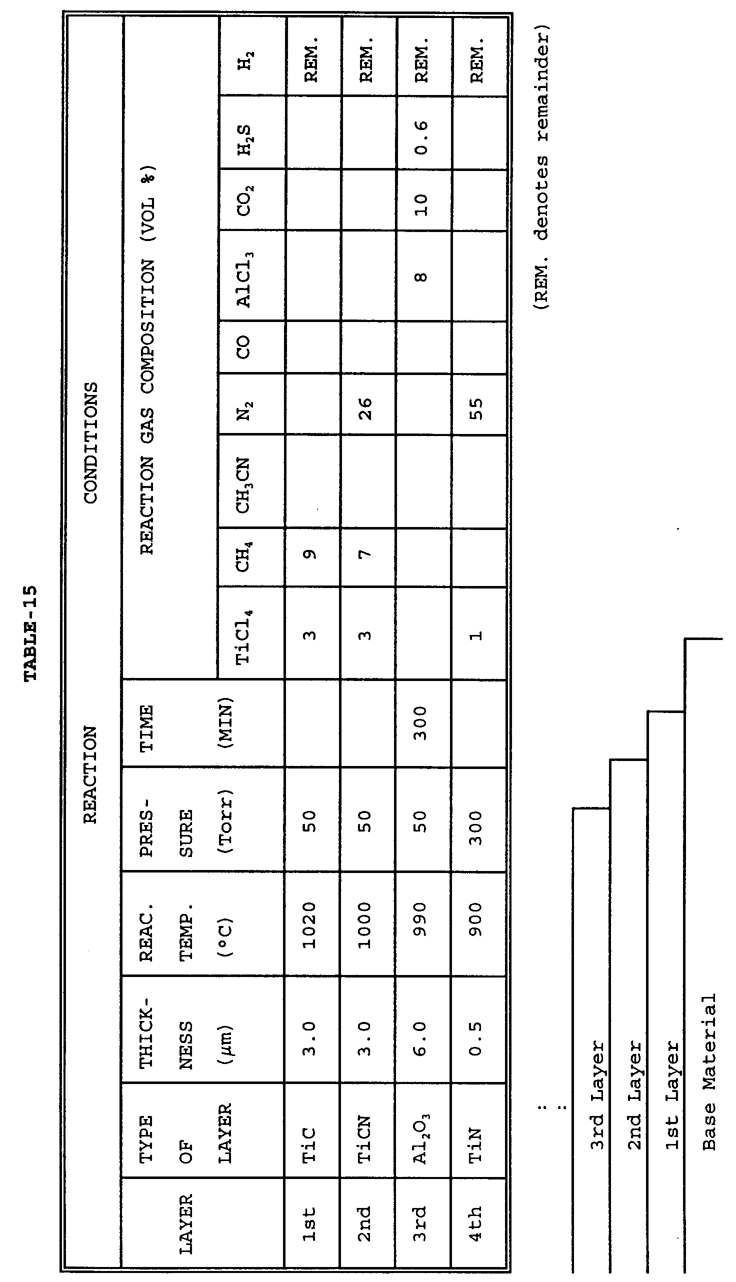

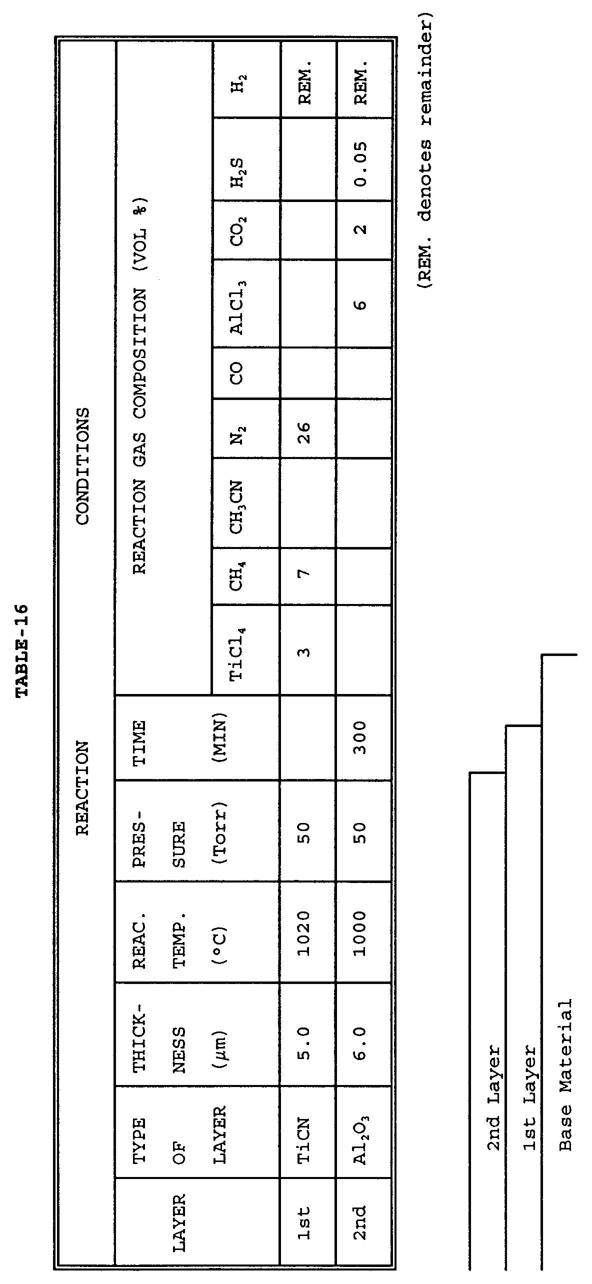

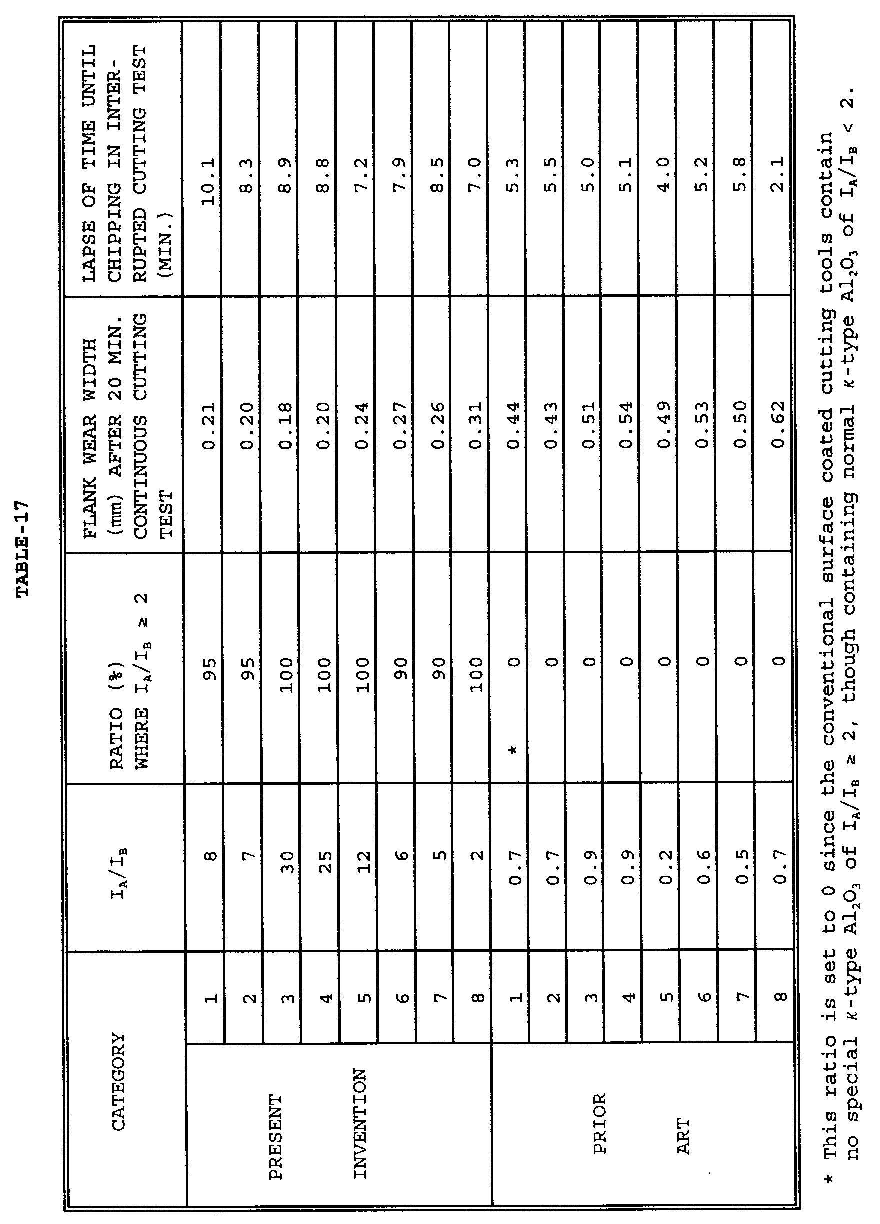

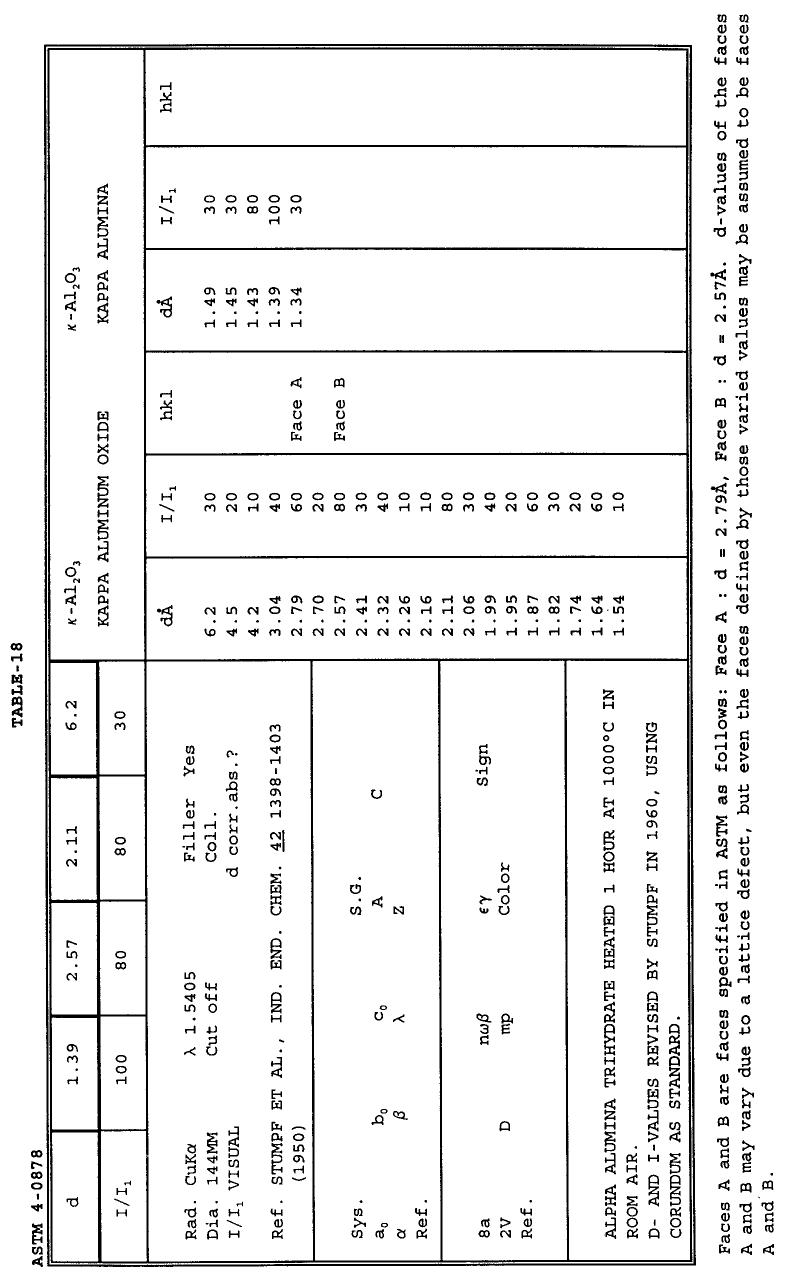

### [Effect of the invention]

As is clear from the results shown in TABLE-17, the value of I_{A}/I_{B} of κ-type alumina of any of the inventive cutting tools 1 to 8 is not smaller than 2. On the contrary, the value of I_{A}/I_{B} of κ-type alumina of any of the conventional cutting tools 1 to 8 is smaller than 2. Further, any of the inventive cutting tools 1 to 8 demonstrates a smaller wear width on the flank face in the continuous cutting test and has a longer lapse of time until chipping in the interrupted cutting test, compared with the conventional cutting tools 1 to 8.

Thus, the surface coated cutting tool according to the invention has a better performance than the conventional tools, and the use thereof leads to a reduced frequency of replacement, thereby contributing greatly to development of industries.

## Claims

1. A cutting tool comprising a substrate whose surface is coated with a composite hard layer including an inner layer having one or more layers of titanium carbide, titanium nitride, titanium carbonitride, titanium carboxide, and titanium oxicarbonitride, and an outer layer having at least one alumina layer,
wherein the alumina layer contains so much κ-type alumina that an X-ray intensity ratio I_{A}/I_{B} of two specific crystal faces A and B in X-ray diffraction is not smaller than 2, where the faces A and B denote faces of κ-type alumina defined as those whose interfacial distances are 2.79Å and 2.57Å in ASTM4-0878, and I_{A} and I_{B} denote X-ray intensities of the faces A and B in X-ray diffraction.

2. A cutting tool according to claim 1, wherein the alumina layer contains at least 30 % of κ-type alumina.

3. A cutting tool according to claim 2, wherein the alumina layer contains at least 50 % of κ-type alumina.

4. A cutting tool according to claim 3, wherein the alumina layer contains at least 70 % of κ-type alumina.

5. A cutting tool according to claim 1, wherein the alumina layer containing κ-type alumina is the uppermost layer.

6. A process for producing a cutting tool according to claim 1 by coating the surface of a substrate with a composite hard layer including an inner layer having one or more layers of titanium carbide, titanium nitride, titanium carbonitride, titanium carboxide, and titanium oxicarbonitride and an outer layer having at least one alumina layer, wherein the substrate coated with titanium compounds is held in a mixed gas containing no CO₂ gas but AlCl₃, H₂ and, if necessary, HCl for a predetermined time in the first step and is subsequently caused to react in a mixed gas containing CO₂, AlCl₃, H₂ and, if necessary, HCl in the second step so that an alumina layer containing so much κ-type alumina, that an X-ray intensity ratio I_{A}/I_{B} of two specific crystal faces A and B in X-ray diffraction is not smaller than 2, is produced, where the faces A and B denote faces of κ-type alumina defined as those whose interfacial distances are 2.79Å and 2.57Å in ASTM4-0878 and I_{A} and I_{B} denote X-ray intensities of the faces A and B in X-ray diffraction.

7. A process according to claim 6 characterized in that the mixed gas used for the coating reaction further contains H₂S.

8. A process according to claim 6 characterized in that the conditions for the alumina coating reactions in the first step are a temperature of 800 to 1050°C, a time of 1 to 120 minutes, a gas composition of 0.5 to 20 vol % of AlCl₃, 0 to 20 vol % of HCl, remainder H₂ and in the second step a temperature of 800 to 1050°C and gas composition of 0.5 to 30 vol % of CO₂, 0.5 to 20 vol % of AlCl₃, 0 to 20 vol % of HCl, remainder H₂.

9. A process according to claim 8 wherein 0.01 to 5 vol % of H₂S have been added at the beginning or in the middle of the second step.

10. A process according to claim 8 wherein the composition of the mixed gas is changed continuously during the transition from the first step to the second step.
